**Europäisches Patentamt**

**European Patent Office**

**Office européen des brevets**

(19)

(11) Publication number : **0 464 662 B1**

# EUROPEAN PATENT SPECIFICATION

(12)

(45) Date of publication of patent specification :
25.10.95 Bulletin 95/43

(51) Int. Cl.$^6$ : **G01R 31/08**

(21) Application number : **91110646.6**

(22) Date of filing : **27.06.91**

(54) **Method and means for fault location in a multi-terminal network.**

(30) Priority : **29.06.90 SE 9002287**

(43) Date of publication of application :
**08.01.92 Bulletin 92/02**

(45) Publication of the grant of the patent :
**25.10.95 Bulletin 95/43**

(84) Designated Contracting States :
**DE FR GB IT**

(56) References cited :
EP-A- 0 226 210
SU-A- 434 340
SU-A- 1 218 354
US-A- 4 719 580

(73) Proprietor : **ASEA BROWN BOVERI AB**
**S-721 83 Västeras (SE)**

(72) Inventor : **Eriksson, Leif**
**Hyttan 2094**
**S-733 91 Sala (SE)**
Inventor : **Saha, Murari Mohan**
**Värmlandsvägen 11**
**S-722 44 Västeras (SE)**

(74) Representative : **Boecker, Joachim, Dr.-Ing.**
**Adelonstrasse 58**
**D-65929 Frankfurt am Main (DE)**

## Description

The invention relates to a method and means for fault location in a multi-terminal network according to the precharacterising part of claim 1.

It is relatively usual to install branch power lines from a main power line between two supply stations, leading to various consumer areas. This may be done either by connecting a branch power line directly or via a transformer to the main power line. It is not usual to measure either current or voltage at the tap points. However, in most cases measurement is possible at terminals in the supply stations and at the end points of the branch power lines.

In this type of network configuration it is difficult for protective relays and fault-locating means of conventional type to conclusively determine a fault.

Relay protection means for power lines often comprise so-called impedance relays. Such a relay compares the quotient between measured voltage and current, i. e. the impedance in a measuring point, with a pre-set value in the protection means, and reaction of the relay is obtained when the measured impedance becomes lower than the set value.

Besides the ability to measure impedance, such protection generally includes several other features increasing the protection provided, such as directional and reach properties, etc. Directional properties enable the protection means to determine whether a fault lies ahead of a measuring point or behind the measuring point. Reach properties enable the protection means to determine the distance from the measuring point within which the protection means shall function.

Since in network configurations of the above-mentioned type measurements can normally not be taken at the tap points, the impedance protection means will not be able immediately to determine where a fault has occurred after it has been indicated. These problems have been known for a long time and some experiences from attempts at solving them are reported, for instance, in "A Review of Impedance-based Fault Locating Experience" by Dr. E.O Schweitzer, presented at The 15th Annual Western Protective Relay Conference, Spokane, Washington, Oct 24-27, 1988. On pages 12 and 13 various procedures are described in a so-called T-network, i.e. a three-terminal network. If a single fault locator is used in a T-network, faults are indicated correctly only up the tap point, but no further. For faults beyond the tap point, infeed from the other station will cause the fault distance to be over-estimated. It is also mentioned in the article that, from the fault-location point of view, the simplest manner of mastering a T-network with substantial infeed at each of the three terminals is to place a fault locator in each terminal. When a fault has occurred, evaluation is effected by comparing all three determinations of the fault distance and then assuming that the correct distance is the one lying between a terminal and a tap point.

US-A-4 719 580 describes a method and means for localizing a fault point on a line on the basis of voltage waves emanating from a measuring point towards a fault point and corresponding waves reflected from the fault point. The method is based on a travelling wave model of the line and calculates, using current and voltage values measured at the end point of the line, the voltage in a number of check-points along the line.

With knowledge of a line's data between an end point with a terminal and a tap point, the method can be used to calculate the voltage in the tap point. Other calculating methods are described, for instance, in "ELEKTRICITETSLÄRA" (Electro-magnetic field theory), by Erik Hallén, Stockholm 1953, page 282 - 284 (chapter 24.3).

The invention aims at developing a method and means for fault location in a multi-terminal network of the above-mentioned kind where measured values of current or voltage at the tap points are not available.

To achieve this aim the invention suggests a method for fault location in a multi-terminal network according to the introductory part of claim 1, which is characterized by the features of the characterizing part of claim 1.

A further development of the method according to the invention is characterized by the features of additional claim 2.

A means for carrying the method according to the invention is characterized by the features of the additional claim 3.

The method according to the invention enables, with the aid of values measured in the terminals, to determine any part of the network which may be faulty, whereafter conventional fault-locating means can be used to specify where on the main or branch power line an indicated fault exists.

A condition for performance of the invention is that the network in question can be represented by a line model based on knowledge of the characteristic data of the line, distance between branch lines, etc.

The currents and voltages measured in all the terminals by the relay protection means are transmitted to an evaluation unit and entered into the line model. The voltages in the tap points can then be calculated as described above. If the calculated voltages in a tap point are the same when calculated with the aid of readings from various terminals or from a terminal and some other tap point, the conclusion can be drawn that the line sections up to the tap point are fault-free. If, on the other hand, the calculated voltage in a tap point calculated from the readings in one terminal differs from the calculated voltage in the same tap point calculated from the readings in another terminal point or another tap point, this indicates a fault in the network.

By successively comparing calculated voltages in tap points, a main power line with branch lines can be checked for faults. When it has been established in the manner described above that a fault exists in the network, a selection system can be used according to the invention to determine in which line section or branch line the fault is located. Once the line section or branch line has been identified, an impedance-based method can be used, for instance, to carry out an accurate determination of the distance to the fault.

The type of fault can also be determined from the calculated voltages, i.e. it can be established whether there is a short-circuit between the phases or an earth-fault and whether it is a single or multi-phase fault.

By way of example, the invention will now be described in greater detail with reference to the accompanying drawings showing in

Figure 1        a main power line with a number of tap points. It also reveals the designation system with indexing which will be used in describing the method according to the invention,

Figure 2        a flow chart for the fault-localizing procedure according to the invention,

Figure 3        a tap point having several branch lines.

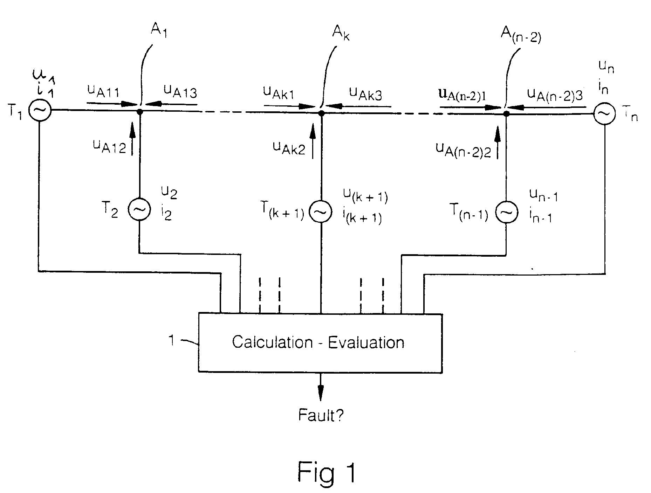

Figure 1 shows a main power line between two supply stations with terminals $T_1$ and $T_n$. Branch lines to various consumers, having terminals $T_2$ to $T_{(n-1)}$ initiate from the tap points $A_1$ to $A_{(n-2)}$. The voltages $u_1, u_2,...u_n$, and currents $i_1, i_2,...i_n$, measured in the terminals, are supplied to a calculation and evaluation unit 1.

As mentioned earlier, the evaluation unit is provided in known manner with characteristic data for the power network in question and, with the input data from the terminals. It can now calculate the voltages in all tap points. With a single branch line at each tap point, as shown in Figure 1, three voltage values can be obtained, i.e. a value from the preceding line section, a value from the branch line section and a value from the following line section. To allow simple reference to these voltage values in the following evaluation, the following designation system and indexing, exemplified for tap point $A_k$, will always be used:

Voltage in $A_k$ calculated from calculated current and voltage in the preceding tap point $A_{(k-1)}$: $u_{Ak1}$.

Voltage in $A_k$ calculated from measured current and voltage values in terminal $T_{(k+1)}$: $u_{Ak2}$.

Voltage in $A_k$ calculated from calculated current and voltage in the following tap point $A_{(k+1)}$ = $u_{Ak3}$.

However, it should be noted that the voltage $u_{A11}$ for the first tap point will be calculated from the readings in terminal $T_1$. Similarly the voltage $u_{A(n-2)3}$ in the final tap point $A_{(n-2)}$ will be calculated from the readings in terminal $T_n$.

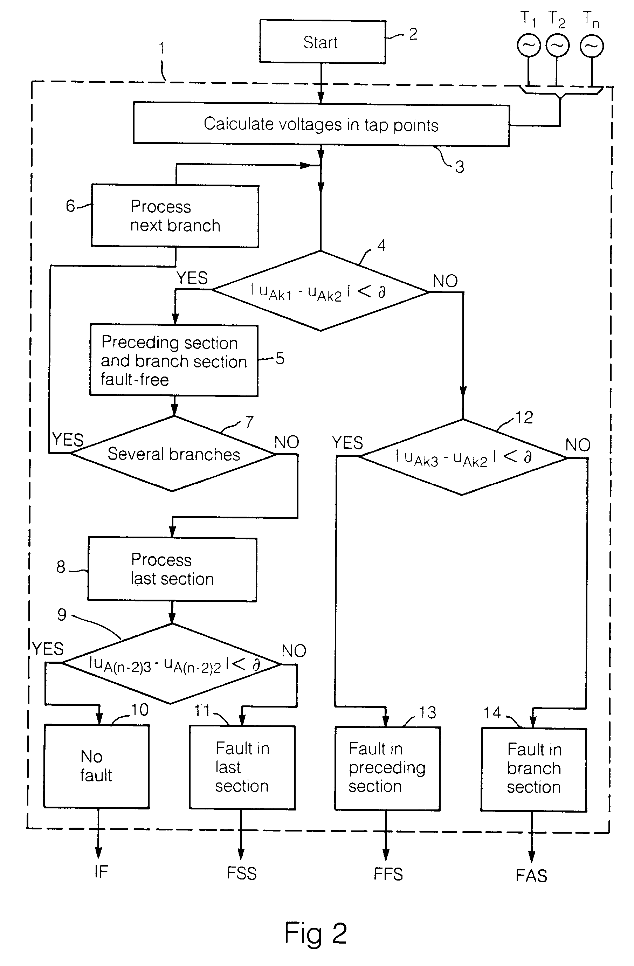

The fault location procedure will now be described with the help of the flow chart shown in Figure 2. Since the procedure, based on the study of calculated voltages in the tap points, is the same for all tap points, the principle can suitably be described for the $A_k$th tap point and associated branch line in Figure 1 although the fault location procedure normally starts by processing the first tap point first.

After having initiated the procedure for fault location via a start unit 2 according to Figure 2, the calculation unit 3 will calculate currents and voltages in the tap points as described above, with the aid of readings from all the terminals.

If, as stated above, the line sections connected to tap point $A_k$ are to be tested for faults, a first selector 4 is permitted to test whether the calculated voltage in $A_k$ based on the voltage in the preceding tap point, i.e. $u_{Ak1}$, is equal to the voltage based on readings in terminal $T_{(k+1)}$, i.e. $u_{Ak2}$. Since the accuracy of measurement and calculation is limited to a certain extent, and the characteristic data of the network are also stated with a certain tolerance, the comparison of the voltages is performed by investigating whether the numerical value of the difference between the voltages is less than a certain tolerance or threshold value $\delta$, i.e. the selector is permitted to test whether

$$|u_{Ak1} - u_{Ak2}| < \delta$$

If the calculated numerical value is less than $\delta$, it can be concluded that the line section between tap points $A_{(k-1)}$ and $A_k$ and the branch line to terminal $T_{(k+1)}$ are fault-free. This is shown symbolically at 5 in Figure 2.

The fault location procedure can then be continued by processing the voltages in the next and following tap points. The order to continue is shown symbolically at 6. This loop is closed by the selector 4 now having to determine whether

$$|u_{A(k+1)1} - u_{A(k+1)2}| < \delta$$

and so on, provided the difference between the voltages is less than $\delta$.

A second selector 7 is provided to allow completion of the search sequence at the last tap point by checking if there are any more branches to be investigated. If the answer is "YES", the investigation will continue for the next tap point. If the answer is "NO", a check must be made as to whether the last line section between the last tap point and the supply point at the last terminal shall be tested. The order for processing of the final section is shown symbolically at 8.

3

It is now presumed that

$$|u_{A(n-2)1} - u_{A(n-2)2}| < \delta$$

A third selector 9 then tests whether

$$|u_{A(n-2)3} - u_{A(n-2)2}| < \delta$$

If the answer is "YES" this means that this line section is also fault-free. This information, i.e. this "YES", is converted symbolically in the unit 10 which indicates externally by "IF" that there is no fault in the line system.

If, on the other hand, the selector 9 answers "NO", i.e.

$$|u_{A(n-2)3} - u_{A(n-2)2}| > \delta$$

this means that a fault exists in the last line section. This information is then converted symbolically in unit 11 which indicates externally by "FSS" that a fault exists in the last line section.

If, however, the first selector 3 indicates "NO", i.e. that

$$|u_{Ak1} - u_{Ak2}| > \delta$$

this means that the fault is either in the line section between tap points $A_{(k-1)}$ and $A_k$ or on the branch line between tap point $A_k$ and terminal $T_{(k+1)}$. To investigate which of these is faulty, the calculated voltage in tap point $A_k$ is then compared in a fourth selector 12, based on the calculated voltage in the tap point $A_{(k+1)}$, with the voltage in the tap point $A_k$ calculated from the value measured in terminal $T_{(k+1)}$, i.e. a test is performed to check if

$$|u_{Ak3} - u_{Ak2}| < \delta$$

If the answer is "YES", this information is converted symbolically in unit 13 which indicates externally by "FSS" that a fault exists in the line section between tap point $A_{(k-1)}$ and $A_k$.

If the answer is "NO", this information is converted symbolically in unit 14 which indicates externally by "FAS" that a fault exists in the branch line section between tap point $A_k$ and terminal $T_{(k+1)}$.

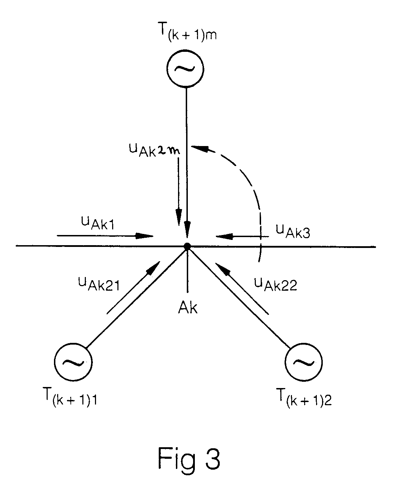

The fault location procedure described so far applies to a line system where only one branch line originates from each tap point. In some cases, however, several branch lines may emanate from one or more of the tap points as exemplified in Figure 3. This entails no problems in fault location provided that all the branch lines have terminals able to take measurement. In this case the voltage calculated in the tap point based on the preceding line section, is compared with the calculated voltages in the tap point based on the voltages measured in each turn in the terminals $T_{(k+1)1}$, $T_{(k+1)2}$,....$T_{(k+1)m}$, i.e. $u_{Ak1}$ is compared as above with $u_{Ak21}$, $u_{Ak22}$,....$u_{Ak2m}$.

The tolerance value $\delta$ used above may of course depend on the accuracy of the characteristic data for the various line sections, etc. stored in the calculation and evaluation unit.

## Claims

1. Method for fault location in a multi-terminal network consisting of a main power line having branch power lines leading from a number of tap points ($A_1$,...$A_{(n-2)}$) to various consumer areas and where terminals ($T_1$,....$T_n$) exist in the end stations of both the main power line and the branch power lines, said terminals measuring the prevailing current ($i_1$,.....$i_n$) and voltage ($u_1$,....$u_n$), which readings are transferred to and combined in a common calculation and evaluation unit (1) which calculates, with knowledge of the characteristic data of the line sections and branch lines and by using known methods, currents and voltages in all the tap points, thereby obtaining for each tap point ($A_k$)

   - a voltage $u_{Ak1}$ calculated from the calculated current and voltage values of the previous tap point ($A_{(k-1)}$) or from the current and voltage values measured in one end terminal ($T_1$) of the main power line,
   - a voltage $u_{Ak2}$ calculated from the current and voltage values measured in the terminal ($T_{(k+1)}$) of the branch line originating from the tap point ($A_k$),
   - a voltage $u_{Ak3}$ calculated from the calculated current and voltage values of the subsequent tap point ($A_{k+1}$) or from measured current and voltage values in the other end terminal ($T_n$) of the main power line,

   characterized in that for each tap point ($A_k$) in turn it is tested whether

   $|u_{Ak1} - u_{Ak2}| < \delta$, where $\delta$ is a given tolerance value,

   and if such is the case, it is established that both the line section from the preceding tap point and the branch line are fault free (IF),

   and if such is not the case, it is tested in corresponding manner, one by one, if

   $$|u_{Ak3} - u_{Ak2}| < \delta$$

   and if such is the case, it is established that there is a fault in the preceding line section (FFS),

   and if such is not the case, it is established that there is a fault in a branch line (FAS).

2. Method according to claim 1 for fault locating in a multi-terminal network in which one or more of the tap points has/have several branch lines (m), each with its own terminal comprising measuring means for current and voltage,

**characterized** in that it is tested whether the difference between the voltage $u_{Ak1}$ in a tap point ($A_k$) calculated from the calculated values for the preceding tap point and the voltage calculated from the voltages $u_{Ak21}$, $u_{Ak22}$,....$u_{Ak2m}$ of the several branch lines (m) in the tap point is less than a tolerance value $\delta$, i.e. if

$$| u_{Ak1} - u_{Ak2m} | < \delta$$

after which, depending on the outcome, the fault-locating method coincides with the method according to the characterizing part of claim 1.

3. Means for performing the method for fault location according to claim 1 or 2 in a multi-terminal network, said multi-terminal network consisting of a main power line having branch power lines leading from a number of tap points ($A_1$,...$A_{(n-2)}$) and where the end stations of both the main power line and the branch power lines are provided with terminals ($T_1$,....$T_n$) for measuring the prevailing current ($i_1$,....$i_n$) and voltage ($u_i$,....$u_n$), which readings are transferred to and combined in a common calculation and evaluation unit (1) which calculates, with knowledge of the characteristic data of the line sections and branch lines and by using known methods, currents and voltages in all the tap points, thereby obtaining for each tap point ($A_k$)

- a voltage $u_{Ak1}$ calculated from the calculated current and voltage values of the previous tap point ($A_{k-1}$) or from the current and voltage values measured in one end terminal ($T_1$) of the main power line,
- a voltage $u_{Ak2}$ calculated from the current and voltage values measured in the terminal ($T_{(k+1)}$) of the branch line originating from the tap point ($A_k$),
- a voltage $u_{Ak3}$ calculated from the calculated current and voltage values of the subsequent tap point ($A_{k+1}$) or from measured current and voltage values in the other end terminal ($T_n$) of the main power line,

**characterized** in that it comprises
a first selector (3) arranged to test whether
$| u_{Ak1} - u_{Ak2} | < \delta$, where $\delta$ is a given tolerance value,
and if such is the case, a second selector (7) is arranged to test whether all tap points have been checked by the first selector,
and when all tap points have been tested, a third selector (9) is arranged to test for the final tap point ($A_{(n-2)}$) whether

$$| u_{A(n-2)3} - u_{A(n-2)2} | < \delta$$

and if such is the case, the means indicates that no fault (IF) exists
and if such is not the case, the means indicates that a fault (FSS) exists in the last line section, and
if the outcome of the first selector indicates that

$$| u_{Ak1} - u_{Ak2} | > \delta$$

a fourth selector (12) is arranged to test whether

$$| u_{Ak3} - u_{Ak2} | < \delta$$

and if such is the case, the means indicates that a fault exists on the preceding line section
and if such is not the case, the means indicates that a fault exists on the branch line section.

**Patentansprüche**

1. Verfahren zur Fehlerlokalisierung in einem Netzwerk mit mehreren Endpunkten, welches Netzwerk aus einer Hauptstarkstromleitung und Abzweigstarkstromleitungen besteht, die von einer Anzahl von Abzweigpunkten ($A_1$, ...$A_{(n-2)}$) der Hauptstarkstromleitung zu verschiedenen Verbraucherbereichen abgehen, wobei in den Endpunkten ($T_1$,...$T_n$) der Endstationen sowohl der Hauptstarkstromleitung als auch der Abzweigstarkstromleitungen die dort auftretenden Ströme ($i_1$, ...$i_n$) und Spannungen ($u_1$, ...$u_n$) gemessen werden, deren Meßwerte an eine gemeinsame Berechnungs- und Bewertungseinheit (1) übertragen und dort kombiniert werden, in welcher Einheit (1) anhand der charakteristischen Daten der Leitungsabschnitte und der Abzweigleitungen und unter Anwendung bekannter Verfahren die Ströme und Spannungen in allen Abzweigpunkten berechnet werden und dabei für jeden Abzweigpunkt ($A_k$) ermittelt werden,

- eine Spannung ($u_{Ak1}$), berechnet aus den berechneten Strom- und Spannungswerten des vorhergehenden Abzweigpunktes ($A_{k-1}$) oder aus den Strom- und Spannungswerten, die in einem Endpunkt ($T_1$) der Hauptstarkstromleitung gemessen wurden,
- eine Spannung ($u_{Ak2}$), berechnet aus den Strom- und Spannungswerten des Endpunktes ($T_{k+1}$) der vom Abzweigpunkt ($A_k$) abgehenden Abzweigleitung,

- eine Spannung ($u_{Ak3}$), berechnet aus den Strom- und Spannungswerten des folgenden Abzweigpunktes ($A_{k+1}$) oder aus den gemessenen Strom- und Spannungswerten in dem anderen Endpunkt ($T_n$) der Hauptstarkstromleitung,

**dadurch gekennzeichnet**, daß nacheinander für jeden Abzweigpunkt ($A_k$) geprüft wird, ob
$|u_{Ak1} - u_{Ak2}| < \delta$, wobei $\delta$ ein vorgegebener Toleranzwert ist,
und, wenn diese Bedingung erfüllt ist, festgestellt wird, daß sowohl der Leitungsabschnitt des vorhergehenden Abzweigpunktes und die Abzweigleitung fehlerfrei sind (IF),
und, wenn diese Bedingung nicht erfüllt ist, in entsprechender Weise nacheinander geprüft wird, ob
$$|u_{Ak3} - u_{Ak2}| < \delta$$
und, wenn diese Bedingung erfüllt ist, festgestellt wird, daß der vorhergehende Leitungsabschnitt (FSS) fehlerhaft ist,
und, wenn diese Bedingung nicht erfüllt ist, festgestellt wird, daß die Abzweigleitung (FAS) fehlerhaft ist.

2. Verfahren nach Anspruch 1 zur Fehlerlokalisierung in Netzwerken mit mehreren Endpunkten, in welchem Netzwerk einer oder mehrere der Abzweigpunkte mehrere Abzweigleitungen (m) hat/haben, wobei jede ihre eigene Endstation mit Meßgliedern für Strom und Spannung hat, **dadurch gekennzeichnet**, daß geprüft wird, ob die Differenz zwischen der Spannung ($u_{Ak1}$) in einem Abzweigpunkt ($A_k$), berechnet aus den berechneten Werten für den vorhergehenden Abzweigpunkt, und der Spannung, die aus den Spannungen $u_{Ak21} - u_{Ak22}, ... u_{Ak2m}$ der mehreren von dem Abzweigpunkt abgehenden Abzweigleitungen (m) berechnet wurde, kleiner ist als ein Toleranzwert $\delta$, das heißt, wenn
$$|u_{Ak1} - u_{Ak2m}| < \delta$$
wonach, abhängig vom Ergebnis, das Fehlerlokalisierungsverfahren mit der im kennzeichnenden Teil des Anspruches 1 genannten Verfahren übereinstimmt.

3. Einrichtung zur Durchführung des Verfahrens zur Fehlerlokalisierung gemäß Anspruch 1 oder 2 in einem Netzwerk mit mehreren Endpunkten, welches Netzwerk aus einer Hauptstarkstromleitung mit Abzweigstarkstromleitungen besteht, welche von einer Anzahl von Abzweigpunkten ($A_1,...A_{(n-2)}$) abgehen, wobei die Endstationen sowohl der Hauptstarkstromleitung als auch der Abzweigstarkstromleitungen Endpunkte ($T_1,...T_n$) haben, in denen die dort auftretenden Ströme ($i_1, ...i_n$) und Spannungen ($u_1, ...u_n$) gemessen werden, deren Meßwerte an eine gemeinsame Berechnungs- und Bewertungseinheit (1) übertragen und dort kombiniert werden, in welcher Einheit (1) anhand der charakteristischen Daten der Leitungsabschnitte und der Abzweigleitungen und unter Anwendung bekannter Verfahren die Ströme und Spannungen in allen Abzweigpunkten berechnet werden und dabei für jeden Abzweigpunkt ($A_k$) ermittelt werden,
- eine Spannung ($u_{Ak1}$), berechnet aus den berechneten Strom- und Spannungswerten des vorhergehenden Abzweigpunktes ($A_{k-1}$) oder aus den Strom- und Spannungswerten, die in einem Endpunkt ($T_1$) der Hauptstarkstromleitung gemessen wurden,
- eine Spannung ($u_{Ak2}$), berechnet aus den Strom- und Spannungswerten des Endpunktes ($T_{k+1}$) der vom Abzweigpunkt ($A_k$) abgehenden Abzweigleitung,
- eine Spannung ($u_{Ak3}$), berechnet aus den Strom- und Spannungswerten des folgenden Abzweigpunktes ($A_{k+1}$) oder aus den gemessenen Strom- und Spannungswerten in dem anderen Endpunkt ($T_n$) der Hauptstarkstromleitung,

**dadurch gekennzeichnet**, daß eine erste Verzweigung (Entscheidung) (3) vorhanden ist, welche prüft, ob
$|u_{Ak1} - u_{Ak2}| < \delta$, wobei $\delta$ ein vorgegebener Toleranzwert ist,
und, wenn diese Bedingung erfüllt ist, eine zweite Verzweigung (7) vorhanden ist zur Prüfung, ob alle Abzweigpunkte durch die erste Verzweigung überprüft wurden,
und wenn alle Abzweigpunkte überprüft worden sind, eine dritte Verzweigung (9) vorhanden ist, um für den letzten Abzweigpunkt ($A_{(n-2)}$) zu prüfen, ob
$$|u_{A(n-2)3} - u_{A(n-2)2}| < \delta$$
und, wenn diese Bedingung erfüllt ist, durch die Einrichtung angezeigt wird, daß kein Fehler (IF) vorhanden ist,
und, wenn diese Bedingung nicht erfüllt ist, von der Einrichtung angezeigt wird, daß ein Fehler (FFS) auf dem letzten Leitungsabschnitt vorhanden ist, und,
wenn der Ausgangswert der erste Verzweigung anzeigt, daß
$$|u_{Ak1} - u_{Ak2}| > \delta$$
eine vierte Verzweigung (12) vorhanden ist zur Prüfung, ob
$$|u_{Ak3} - u_{Ak2}| < \delta$$
und, wenn diese Bedingung erfüllt ist, die Einrichtung anzeigt, daß ein Fehler auf dem vorhergehenden

6

Leitungsabschnitt vorhanden ist,
und, wenn diese Bedingung nicht erfüllt ist, die Einrichtung anzeigt, daß ein Fehler auf der Abzweigleitung vorhanden ist.

**Revendications**

1. Procédé pour localiser des défauts dans un réseau à plusieurs terminaux consistant en une ligne électrique principale ayant des lignes électriques de dérivation qui partent d'un certain nombre de points de dérivation ($A_1$, ... $A_{(n-2)}$) vers diverses zones de consommateurs, et dans lequel il existe des terminaux ($T_1$, ... $T_n$) dans les stations d'extrémités aussi bien de la ligne électrique principale que des lignes électriques de dérivation, ces terminaux mesurant le courant ($i_1$, ...$i_n$) et la tension ($u_1$, ... $u_n$) existants, et ces mesures étant transférées et combinées dans une unité de calcul et d'évaluation (1) commune qui, en connaissant les données caractéristiques des sections de ligne et des lignes de dérivation, et en utilisant des procédés connus, calcule des courants et des tensions à tous les points de dérivation, pour obtenir ainsi, pour chaque point de dérivation ($A_k$)

   - une tension $u_{Ak1}$ calculée à partir des valeurs calculées de courant et de tension du point de dérivation précédent ($A_{k-1}$), ou à partir des valeurs de courant et de tension mesurées dans un terminal d'extrémité ($T_1$) de la ligne électrique principale,
   - une tension $u_{Ak2}$ calculée à partir des valeurs de courant et de tension qui sont mesurées dans le terminal ($T_{(k+1)}$) de la ligne de dérivation qui part du point de dérivation ($A_k$),
   - une tension $u_{Ak3}$ calculée à partir des valeurs calculées de courant et de tension du point de dérivation suivant ($A_{k+1}$), ou à partir des valeurs mesurées de courant et de tension dans l'autre terminal d'extrémité ($T_n$) de la ligne électrique principale,

   **caractérisé** en ce que pour chaque point de dérivation ($A_k$), on effectue tour à tour un test pour déterminer si
   $|u_{Ak1} - u_{Ak2}| < \delta$, $\delta$ étant une valeur de tolérance donnée, et si c'est le cas, il est établi que la section de ligne qui part du point de dérivation précédent et la ligne de dérivation sont toutes deux exemptes de défaut (IF), et si ce n'est pas le cas, on effectue un test de façon correspondante, tour à tour pour chaque point de dérivation, pour déterminer si
   $$|u_{Ak3} - u_{Ak2}| < \delta$$
   et si c'est le cas, il est établi qu'il y a un défaut dans la section de ligne précédente (FFS),
   et si ce n'est pas le cas, il est établi qu'il y a un défaut dans une ligne de dérivation (FAS).

2. Procédé selon la revendication 1, pour localiser des défauts dans un réseau à plusieurs terminaux dans lequel un ou plusieurs des points de dérivation ont plusieurs lignes de dérivation (m), ayant chacune son propre terminal comprenant des moyens de mesure de courant et de tension,
   **caractérisé** en ce que l'on effectue un test pour déterminer si la différence entre la tension $u_{Ak1}$ à un point de dérivation ($A_k$), calculée à partir des valeurs calculées pour le point de dérivation précédent, et la tension calculée à partir des tensions $u_{Ak21}$, $u_{Ak22}$, ... $u_{Ak2m}$ des différentes lignes de dérivation (m) au point de dérivation, est inférieure à une valeur de tolérance $\delta$, c'est-à-dire si
   $$|u_{Ak1} - u_{Ak2m}| < \delta$$
   après quoi, en fonction du résultat, le procédé de localisation de défauts coïncide avec le procédé conforme à la partie caractérisante de la revendication 1.

3. Moyens pour mettre en oeuvre le procédé pour localiser des défauts selon la revendication 1 ou 2, dans un réseau à plusieurs terminaux, ce réseau à plusieurs terminaux consistant en une ligne électrique principale ayant des lignes électriques de dérivation qui partent d'un certain nombre de points de dérivation ($A_1$, ... $A_{(n-2)}$), et dans lequel les stations d'extrémités de la ligne électrique principale et des lignes électriques de dérivation sont équipées de terminaux ($T_1$, ... $T_n$) pour mesurer le courant ($i_1$, ... $i_n$) et la tension ($u_1$, ... $u_n$) existants, ces mesures étant transférées et combinées dans une unité de calcul et d'évaluation (1) commune qui, connaissant les données caractéristiques des sections de ligne et des lignes de dérivation, et en utilisant des procédés connus, calcule des courants et des tensions à tous les points de dérivation, pour obtenir ainsi, pour chaque point de dérivation ($A_k$)

   - une tension $u_{Ak1}$ calculée à partir des valeurs calculées de courant et de tension du point de dérivation précédent ($A_{k-1}$), ou à partir des valeurs de courant et de tension mesurées dans un terminal d'extrémité ($T_1$) de la ligne électrique principale,
   - une tension $u_{Ak2}$ calculée à partir des valeurs de courant et de tension qui sont mesurées dans le

terminal ($T_{(k+1)}$) de la ligne de dérivation qui part du point de dérivation ($A_k$),

- une tension $u_{Ak3}$ calculée à partir des valeurs calculées de courant et de tension du point de dérivation suivant ($A_{k+1}$), ou à partir des valeurs mesurées de courant et de tension dans l'autre terminal d'extrémité ($T_n$) de la ligne électrique principale,

**caractérisé** en ce qu'ils comprennent un premier sélecteur (3) conçu pour effectuer un test de façon à déterminer si

$|u_{Ak1} - u_{Ak2}| < \delta$, $\delta$ étant une valeur de tolérance donnée et si c'est le cas, un second sélecteur (7) effectue un test pour déterminer si tous les points de dérivation ont été contrôlés par le premier sélecteur,

et lorsque tous les points de dérivation ont été testés, un troisième sélecteur (9) effectue un test portant sur le point de dérivation final ($A_{(n-2)}$), pour déterminer si

$$|u_{A(n-2)3} - u_{A(n-2)2}| < \delta$$

et si c'est le cas, les moyens indiquent qu'il n'existe aucun défaut (IF)

et si ce n'est pas le cas, les moyens indiquent qu'il existe un défaut (FSS) dans la dernière section de ligne, et

si le résultat qui est fourni par le premier sélecteur indique que

$$|u_{Ak1} - u_{Ak2}| > \delta$$

un quatrième sélecteur (12) effectue un test pour déterminer si

$$|u_{Ak3} - u_{Ak2}| < \delta$$

et si cela est le cas, les moyens indiquent qu'il existe un défaut sur la section de ligne précédente, et si ce n'est pas le cas, les moyens indiquent qu'il existe un défaut sur la section de ligne de dérivation.

Fig 1

T$_1$ T$_2$ T$_n$

1

Start — 2

Calculate voltages in tap points

3

6 — Process next branch

4

YES | u$_{Ak1}$ - u$_{Ak2}$ | < ∂ NO

Preceding section and branch section fault-free — 5

7

YES Several branches NO

12

YES | u$_{Ak3}$ - u$_{Ak2}$ | < ∂ NO

8 — Process last section

9

YES | u$_{A(n-2)3}$ - u$_{A(n-2)2}$ | < ∂ NO

10

No fault

11

Fault in last section

13

Fault in preceding section

14

Fault in branch section

IF

FSS

FFS

FAS

Fig 2

Fig 3